# EUROPEAN PATENT SPECIFICATION

(11) **EP 0 292 641 B1**
(45) Date of publication and mention of the grant of the patent: **18.05.1994**
(21) Application number: 88101710.7
(22) Date of filing: 05.02.1988
(51) Int. Cl.: H01L 27/02, H01L 23/52, H03K 19/094

(54) **Output buffer of MOS semiconductor integrated circuit**
Ausgangspuffer für MOS-integrierte Halbleiterschaltung
Tampon de sortie pour circuit intégré semi-conducteur MOS

(30) Priority: 27.05.1987 JP 130806/87
(43) Date of publication of application: 30.11.1988
(73) Proprietor: KABUSHIKI KAISHA TOSHIBA, Kawasaki-shi, Kanagawa-ken 210 (JP); Toshiba Micro-Computer Engineering Corporation, Kawasaki-shi (JP)
(72) Inventor: Kinugasa, Masanori c/o Patent Division, Minato-ku Tokyo 105 (JP); Shimazaki, Kenichiro, Yokohama-shi (JP); Tanaka, Fuminari c/o Patent Division, Minato-ku Tokyo 105 (JP)
(74) Representative: Henkel, Feiler, Hänzel & Partner

(56) References cited:
- EP-A- 0 002 486
- EP-A- 0 058 504
- US-A- 4 636 825
- US-A- 4 789 793
- IBM TECHNICAL DISCLOSURE BULLETIN, vol. 28, no. 19, February 1986, pages 3970-3971, New York, US; "Improved performance off-chip driver"
- PATENT ABSTRACTS OF JAPAN, vol. 8, no. 264 (E-282), 4th December 1984; & JP-A-59 135 745

## Description

This invention relates to an output buffer of a MOS semiconductor integrated circuit and, more particularly, to a contact between a metal wiring of low resistance for signal input and a gate wiring for each of MOSFETs of an output buffer which are connected in parallel.

Recently, it is required in the field of MOS IC to develop ICs having a signal propagation characteristic as short as that of Schottky transistor-transistor logic (TTL) and a large output current characteristic. In order to meet the requirement, it is necessary to increase the mutual conductance of the MOSFETs constituting the output buffer, for example.

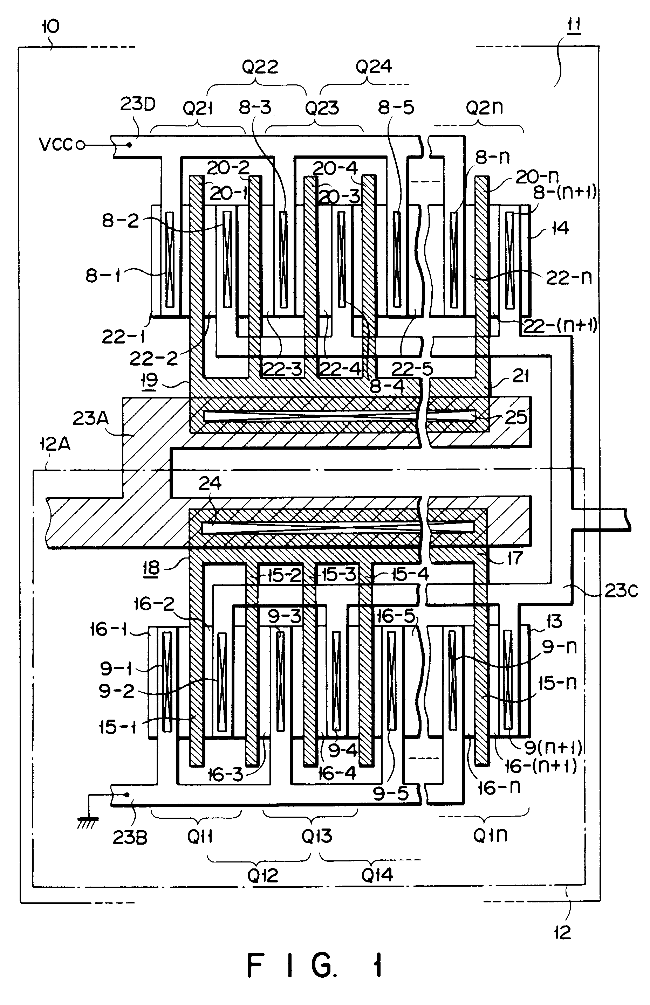

Figs. 1 to 3 show examples of the prior art pattern layout of the CMOS output buffer which can enhance the mutual conductance of the MOSFET formed in a relatively small and limited area. Figs. 1 to 3 are plan views of the patterns of the output buffer having a plurality of MOSFETs. First, the pattern layout of Fig. 1 is explained. Assume that N-type semiconductor substrate 11 is used. Then, P-type well region 12 is formed in semiconductor substrate 11. SDG region 13 for forming the sources (S), drains (D) and gates (G) of N channel MOSFETs Q11 to Q1n is formed in the surface area of well region 12. SDG region 14 for forming the sources (S), drains (D) and gates (G) of P channel MOSFETs Q21 to Q2n is formed in the surface area of semiconductor substrate 11. Gate wiring layers 15-1 to 15-n formed of, for example, a polysilicon layer are formed at a regular interval and extend across SDG region 13 to part of well region 12. Gate wiring layers 15-1 to 15-n are used as gate electrodes of N channel MOSFETs Q11 to Q1n on SDG region 13. N⁺-type regions 16-1 and 16-2 of SDG 13 act as source and drain regions of N channel MOSFET Q11, and N⁺-type regions 16-2 and 16-3 of SDG 13 act as source and drain regions of N channel MOSFET Q12. Other MOSFETs Q13 to Q1n are formed in the same manner as described above. For example, N⁺-type regions 16-n and 16-(n+1) of SDG 13 act as source and drain regions of N channel MOSFET Q1n. Gate wiring contact region 17 formed of the same material as gate wiring layers 15-1 to 15-n, i.e. polysilicon layer is formed in contact with gate wiring layers 15-1 to 15-n. Thus, the polysilicon layer 18 constituting gate wiring layers 15-1 to 15-n and gate wiring contact region 17 is formed in the comb configuration. Tooth portions of the comb are used as gate wiring layers 15-1 to 15-n and base portion thereof is used as gate wiring contact region 17. Polysilicon layer 19 is formed to extend across SDG region 14 to part of semiconductor substrate 11 and arranged symmetrically with polysilicon layer 18 about junction boundary 12A of semiconductor 11 and well region 12. Tooth portions 20-1 to 20-n of polysilicon layer 19 are used as gate wiring layers of P channel MOSFETs Q21 to Q2n, and the base portion thereof is used as gate wiring contact region 21. Gate wiring layers 20-1 to 20-n act as gate electrodes of P channel MOSFETs Q21 to Q2n on SDG region 14. P⁺-type regions 22-1 and 22-2 of SDG region 14 are used as source and drain regions of P channel MOSFET Q21, and P⁺-type regions 22-2 and 22-3 of SDG region 14 are used as source and drain regions of P channel MOSFET Q22. Other MOSFETs are formed in the same manner as described above. For example, P⁺-type regions 22-n and 22-(n+1) of SDG region 14 are used as source and drain regions of P channel MOSFET Q2n. Metal wiring layer 23A such as an aluminum layer of low resistance for signal input is formed on gate wiring contact regions 17 and 21 through insulation layer 10. Contact holes 24 and 25 are formed in insulation layer 10. Gate wiring contact layers (polysilicon layer) 17 and 21 are connected substantially at their entire portions to metal wiring layer 23A through contact holes 24 and 25. Metal wiring layer 23B such as an aluminum layer of low resistance is formed on source regions 16-1, 16-3, ..., and 16-n of N channel MOSFETs Q11 to Q1n through insulation layer 10. Metal wiring layer 23B is grounded. Contact holes 9-1, 9-3, ..., and 9-n are formed in those portions of insulation layer 10 which lie on source regions 16-1, 16-3, ..., and 16-n. Source regions 16-1, 16-3, ..., and 16-n are connected to metal wiring layer 23B through contact holes 9-1, 9-3, ..., and 9-n. Metal wiring layer 23C of low resistance such as an aluminum layer serving as drain electrodes of MOSFETs Q11 to Q1n and Q21 to Q2n is formed on drain regions 16-2, 16-4, ..., and 16-(n+1) and 22-2, 22-4, ..., and 22-(n+1) of N and P channel MOSFETs Q11 to Q1n and Q21 to Q2n through insulation layer 10. Metal wiring layer 23C is used for signal output. Contact holes 9-2, 9-4, ..., and 9-(n+1) and 8-2, 8-4, ..., and 8-(n+1) are formed in those portions of insulation layer 10 which lie on drain regions 16-2, 16-4, ..., and 16-(n+1) and 22-2, 22-4, ..., and 22-(n+1). Drain regions 16-2, 16-4, ..., and 16-(n+1) and 22-2, 22-4, ..., and 22-(n+1) are connected to metal wiring layer 23C through contact holes 9-2, 9-4, ..., and 9-(n+1) and 8-2, 8-4, ..., and 8-(n+1). Metal wiring layer 23D of low resistance such as an aluminum layer serving as source electrodes is formed on source regions 22-1, 22-3, ..., and 22-n of P channel MOSFETs Q21 to Q2n through insulation layer 10. Metal wiring layer 23D is connected to power source Vcc. Contact holes 8-1, 8-3, ..., and 8-n are formed in those portions of insulation layer 10 which lie on source regions 22-1, 22-3, ..., and 22-n. Source regions 22-1, 22-3, ..., and 22-n are connected to metal wiring layer 23D through contact holes 8-1, 8-3, ..., and 8-n.

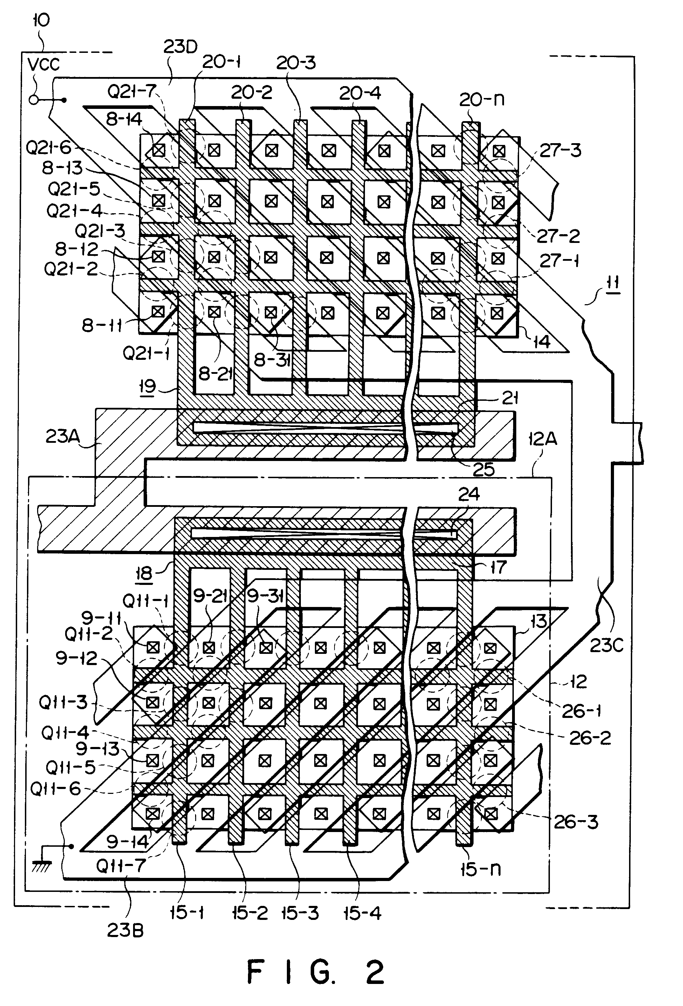

Fig. 2 shows another example of a pattern layout of the prior art output buffer. In Fig. 2, the same portions as those in Fig. 1 are denoted by the same reference numerals. The pattern layout of Fig. 2 differs from that of Fig. 1 in that gate wiring layers are arranged at regular intervals in vertical and horizontal directions in the lattice form and that metal wiring layers 23B, 23C and 23D are obliquely arranged. In Fig. 2, horizontal gate wiring layers 26-1 to 26-3 are formed to intersect vertical gate wiring layers 15-1 to 15-n and horizontal gate wiring layers 27-1 to 27-3 are formed to intersect vertical gate wiring layers 20-1 to 20-n. Impurity regions defined by the gate wiring layers are connected to metal wiring layers 23B, 23C and 23D via contact holes 9-11, 9-12, ..., and 8-11, 8-12, .... The impurity regions function as source or drain regions according to the metal wiring layers to which they are connected. Thus, source and drain regions are alternately arranged. That is, drain regions are formed in right, left, upper and lower positions of one source region, and source regions are formed in right, left, upper and lower positions of one drain region. In the pattern of the gate wiring layers, MOSFETs are formed to have each of the gate wiring layers as a gate electrode, and impurity regions on both sides of the gate electrode as source and drain regions. Some of MOSFETs Q11-1, Q11-2, Q11-3, ..., and Q21-1, Q21-2, Q21-3, ... are indicated by circles of broken lines.

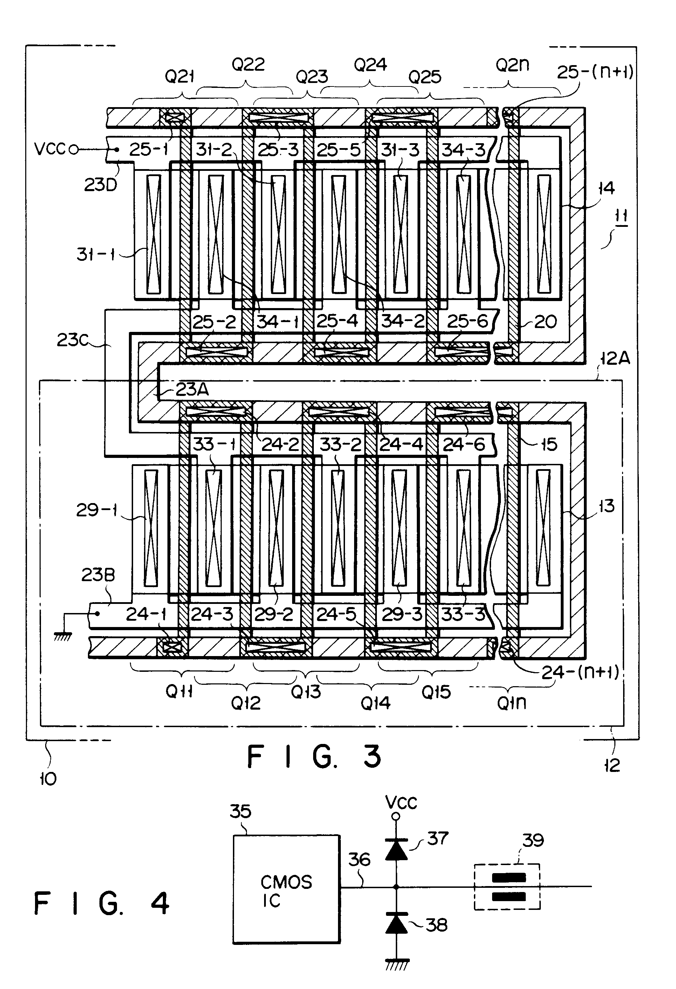

Fig. 3 shows still another example of a pattern layout of the prior art output buffer. In Fig. 3, portions corresponding to those in Figs. 1 and 2 are denoted by the same reference numerals. In the pattern of Fig. 3, gate electrodes for forming MOSFETs Q11 to Q1n which are connected in parallel are formed of one polysilicon layer 15 bent in the form of a rectangular waveform, and gate electrodes for forming MOSFETs Q21 to Q2n are formed of one polysilicon layer 20 bent in the form of a rectangular waveform. Metal wiring layers 23A of low resistance for signal input are formed on the bent portions of polysilicon layers 15 and 20 serving as gate electrodes through insulation layer 10. Contact holes 24-1 to 24-(n+1) and 25-1 to 25-(n+1) are formed in insulation layer 10 in positions under the bent portions of gate electrodes 15 and 20. Gate electrodes 15 and 20 are connected to metal wiring layer 23A via contact holes 24-1 to 24-(n+1) and 25-1 to 25-(n+1) in each of the bent portions. Metal wiring layer 23B for the source electrode is formed on the source regions of SDG region 13 through insulation layer 10. Metal wiring layer 23B is connected to each of the source regions via contact holes 29-1, 29-2, 29-3, ... formed in insulation layer 10. Source metal wiring layer 23D for the source electrode is formed on the source regions of SDG region 14 through insulation layer 10. Source metal wiring layer 23D is connected to each of the source regions via contact holes 31-1, 31-2, 31-3, ... formed in insulation layer 10. Drain metal wiring layer 23C for the drain electrode serving to generate an output signal is formed on the drain regions of SDG regions 13 and 14. Drain metal wiring layer 23C is connected to each of the drain regions via contact holes 33-1, 33-2, 33-3, ... and 34-1, 34-2, 34-3, ... formed in insulation layer 10. With this pattern layout, MOSFETs Q11 to Q1n and Q21 to Q2n are formed to have gate electrodes formed of the vertically extending straight portions of gate wiring layers 15 and 20 and source and drain regions formed of impurity regions lying on both sides of the respective gate electrodes.

As shown in Figs. 1 to 3, the pattern layout of the prior art output buffer is designed so that the signal delay time for a signal to reach the gate electrode of each MOSFET can be made as short as possible. The signal delay time is caused by the resistance of the gate electrode and the gate input capacitance (capacitance by the gate electrode and the semiconductor substrate with the gate oxide film as a dielectric layer) of the MOSFET. In the output buffer with pattern layout shown in Figs. 1 and 3, there is no substantial difference between times for an input signal to reach the gates of MOSFETs Q11 to Q1n and Q21 to Q2n and therefore MOSFETs Q11 to Q1n and Q21 to Q2n are operated at substantially the same time. That is, when P channel MOSFETs Q21 to Q2n are turned on, N channel MOSFETs Q11 to Q1n are turned off at the same time. In contrast, when N channel MOSFETs Q11 to Q1n are turned on, P channel MOSFETs Q21 to Q2n are turned off at the same time. In the case of the pattern layout shown in Fig. 2, an ON/OFF operation speed differs according to the distance from contact holes 24 and 25 to each MOSFET. However, the ON/OFF operations of the MOSFETs are effected substantially at the same time as described with reference to the pattern layout shown in Figs. 1 and 3.

In the pattern layout shown in Figs. 1 to 3, the d.c. resistance component of the MOSFET is reduced with increase in the mutual conductance of the MOSFET. Therefore, the output waveform will be largely affected by capacitive and inductive loads associated with the power source line and output wiring. Thus, distortion such as overshoot and undershoot in the output waveform tends to increase to a certain degree and cannot be neglected. In the prior art, in order to reduce the distortion, a distortion reducing circuit for reducing the distortion in the output waveform is connected to the output terminal of CMOS IC 35 as shown in Fig. 4. The output buffer with the pattern layout as shown in Figs. 1 to 3 is formed in the output section of CMOS IC 35. The signal output terminal of the output buffer is connected to output signal line 36. An anode and a cathode of planar diode 37 for ultraspeed switching are connected to output signal line 36 and power source Vcc. Further, the cathode and anode of planar diode 38 for ultraspeed switching are connected to output signal line 36 and the ground. An output signal is derived from output signal line 36 via inductor 39 formed of, for example, ferrite beads. The distortion reducing circuit formed of planar diodes 37 and 38 and inductor 39 is externally connected to a wiring plate for IC assembly, increasing the mounting area on the wiring plate and leading to the high cost of parts.

Prior art document US-A-4 636 825 discloses a pattern layout similar to those of above Figures 1 and 2. In this pattern layout, a FET structure suitable for MOS and CMOS IC fabrication processes includes spaced apart alternating source and drain regions distributed in a rectangular checkerboard pattern of horizontal and vertical rows. A first grid of intersecting horizontal and vertical conductive gate lines overlaps adjacent source and drain regions of the array and is dielectrically isolated from the source and drain regions by an insulating layer. The horizontal and vertical gate lines provide a single gate element distributed across the array which reduces FET channel length and channel resistance. A second grid comprising a set of parallel diagonal alternating source lead lines and drain lead lines is dielectrically isolated from the first grid. The source lead lines are electrically coupled to source regions and drain lead lines to drain regions. The second grid includes a first metal layer of diagonal source and drain lead lines and a second metal layer overlying at least a portion of the first metal layer. The first and second metal layers are selectively coupled to reduce current density and resistance in the diagonal lead lines withouot increasing the width of the lead lines. Back contact areas or regions are distributed around the perimeter of the checkerboard pattern forming a back contact guard ring or band.

Further, prior art document IBM T.D.B. 28(9), pages 3970/1, Feb. 1986, teaches the use of a resistor chain connected between an input terminal and the gate electrodes of parallel FETs to control the current rise during the turn on phase of an output buffer.

Finally, prior art document EP-A-0 058 504 shows the principle of providing a delay line using the polysilicon gate electrodes of FET transistors.

It is an object of the present invention to provide an output buffer of a CMOS semiconductor integrated circuit in which the distortion of output waveform can be reduced without using externally connected parts in the case where the mutual conductance of MOSFETs is increased, thus permitting the mounting area to be reduced and the cost of parts to be lowered.

To solve this object the present invention provides an output buffer of a MOS semiconductor integrated circuit for amplifying an input signal as specified in claim 1 or 7.

With this construction, since the operation timings of the MOSFETs connected in parallel can be set differently to make the rise and fall of an output signal gentle, an output buffer of a MOS semiconductor integrated circuit in which the distortion of the output waveform can be reduced without using externally connected parts.

This invention can be more fully understood from the following detailed description when taken in conjunction with the accompanying drawings, in which:
Figs. 1 to 3 are pattern plan views of the prior art output buffers;
Fig. 4 is a circuit diagram of a distortion reducing circuit for reducing the output waveform of a CMOS IC using the output buffer of the pattern layout shown in Figs. 1 to 3;
Fig. 5 is a circuit diagram showing the construction of an output buffer according to one embodiment of this invention;
Fig. 6 is a pattern plan view of the output buffer shown in Fig. 5;
Fig. 7 is a characteristic diagram showing the signal propagation characteristic of a signal supplied to the output buffer shown in Fig. 6;
Fig. 8 is a waveform diagram showing output signals from the output buffers of Figs. 1 and 6;
Fig. 9 is a diagram showing the relation between the gate resistance of the output buffer shown in Fig. 6 and the distortion of the output waveform; and
Figs. 10 to 17 are pattern plan views showing the constructions of output buffers according to other embodiments of this invention.

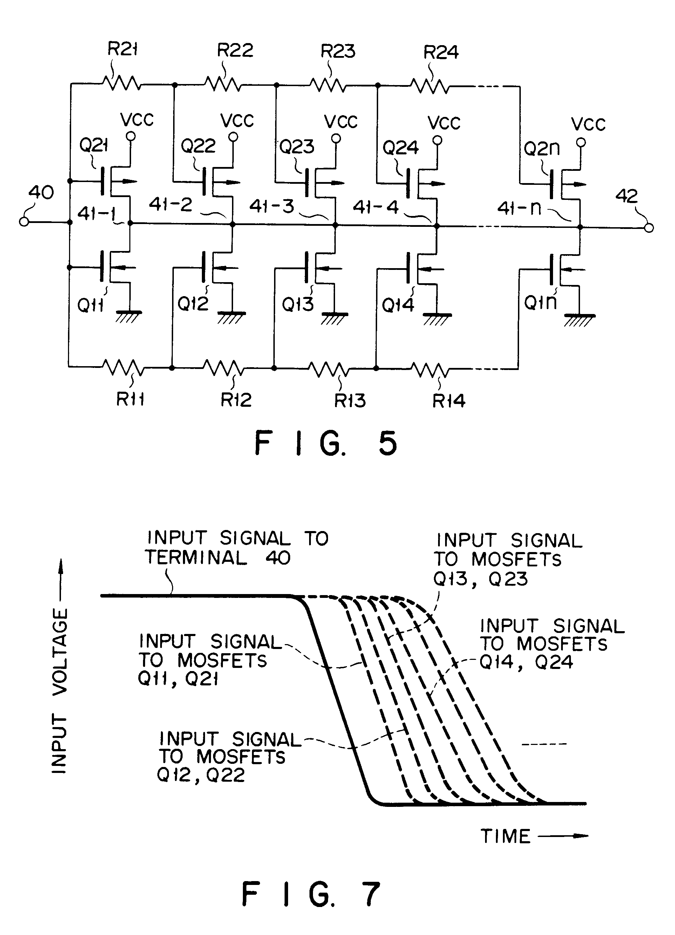

Fig. 5 shows the construction of an output buffer according to one embodiment of this invention. The output buffer shown in this Figure includes several CMOS inverters. Input terminal 40 is connected to receive a signal from an internal circuit, and is connected to an input terminal of first CMOS inverter 41-1 which includes N channel MOSFET Q11 and P channel MOSFET Q21. An output terminal of CMOS inverter 41-1 is connected to output terminal 42. In addition, input terminal 40 is connected to the gate of N channel MOSFET Q12 via resistor R11 and to the gate of P channel MOSFET Q22 via resistor R21. MOSFETs Q12 and Q22 constitute a second CMOS inverter, 41-2, the output terminal of which is connected to output terminal 42 in the same manner as that of first CMOS inverter 41-1. Input terminal 40 is further connected to the gate of N channel MOSFET Q13 via resistors R11 and R12 and to the gate of P channel MOSFET Q23 via resistors R21 and R22. MOSFETs Q13 and Q23 constitute a third CMOS inverter, 41-3, the output terminal of which is connected to output terminal 42 in the same manner as the output terminals of first and second CMOS inverters 41-1 and 41-2. Other CMOS inverters are formed in the same manner as described above. For example, input terminal 40 may be connected to the gate of N channel MOSFET Q1n via resistors R11 to R1(n-1) and to the gate of P channel MOSFET Q2n via resistors R21 to R2(n-1). MOSFETs Q1n and Q2n constitute an n-th CMOS inverter, 41-n, the output terminal of which is connected to output terminal 42 in the same manner as the output terminal of CMOS inverters 41-1 to 41-(n-1).

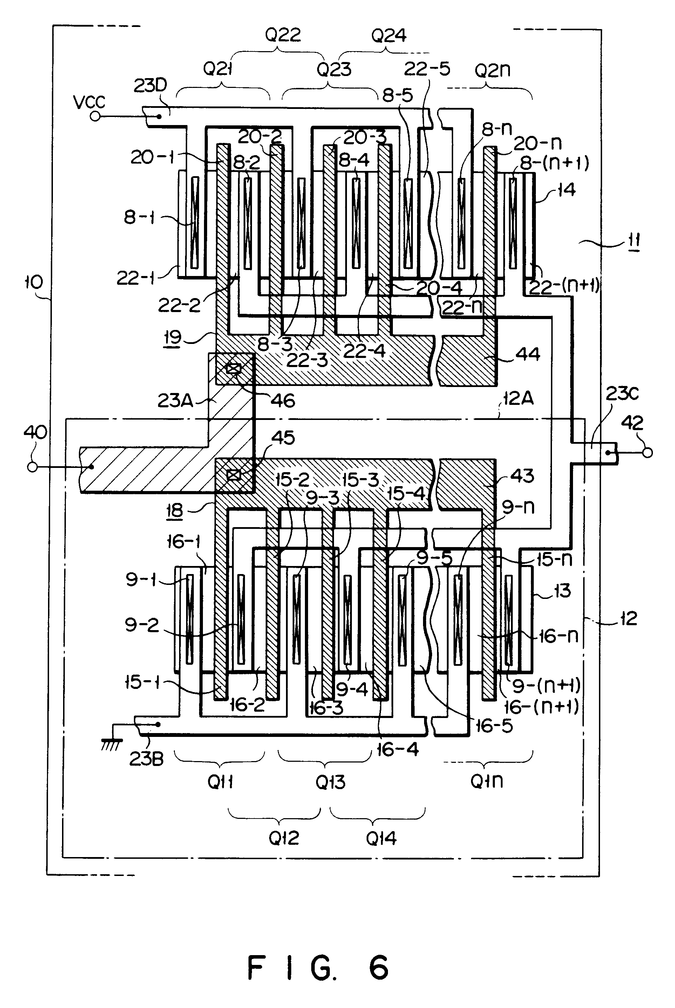

Fig. 6 shows a pattern layout of the output buffer shown in Fig. 5. In Fig. 6, portions corresponding to those in Figs. 1 and 5 are denoted by the same reference numerals. Assume that semiconductor substrate 11 is of N-type as described in Fig. 1. Then, P-type well region 12 is formed in semiconductor substrate 11. The junction boundary between semiconductor substrate 11 and well region 12 is indicated by a one-dot-dash line 12A. SDG region 13 for forming the sources (S), drains (D) and gates (G) of N channel MOSFETs Q11 to Q1n is formed in the surface area of well region 12. SDG region 14 for forming the sources (S), drains (D) and gates (G) of P channel MOSFETs Q21 to Q2n is formed in the surface area of semiconductor substrate 11. Gate wiring layers 15-1 to 15-n formed of, for example, a polysilicon layer are formed at a regular interval and extend across SDG region 13 to part of well region 12. Gate wiring layers 15-1 to 15-n are used as gate electrodes of N channel MOSFETs Q11 to Q1n on SDG region 13. N⁺-type regions 16-1 and 16-2 of SDG region 13 act as source and drain regions of N channel MOSFET Q11, and N⁺-type regions 16-2 and 16-3 of SDG region 13 act as source and drain regions of N channel MOSFET Q12. Other MOSFETs Q13 to Q1n are formed in the same manner as described above. For example, N⁺-type regions 16-n and 16-(n+1) of SDG region 13 act as source and drain regions of N channel MOSFET Q1n. Resistive region 43 formed of the same material as gate wiring layers 15-1 to 15-n, i.e. polysilicon layer is formed in contact with gate wiring layers 15-1 to 15-n. Thus, the polysilicon layer 18 constituting gate wiring layers 15-1 to 15-n and resistive region 43 is formed in the comb configuration. Tooth portions of the comb are used as gate wiring layers 15-1 to 15-n and base portion 43 thereof is used as resistors R11 to R1(n-1) of the Fig. 5 circuit. Polysilicon layer 19 is formed to extend across SDG region 14 to part of semiconductor substrate 11 and arranged symmetrically with comb-like polysilicon layer 18 about junction boundary 12A of semiconductor 11 and well region 12. Tooth portions 20-1 to 20-n of polysilicon layer 19 are used as gate wiring layers of P channel MOSFETs Q21 to Q2n, and the base portion 44 thereof is used as resistors R21 to R2(n-1) shown in Fig. 5. Gate wiring layers 20-1 to 20-n act as gate electrodes of P channel MOSFETs Q21 to Q2n on SDG region 14. P⁺-type regions 22-1 and 22-2 of SDG region 14 are used as source and drain regions of P channel MOSFET Q21, and P⁺-type regions 22-2 and 22-3 of SDG region 14 are used as source and drain regions of P channel MOSFET Q22. Other MOSFETs are formed in the same manner as described above. For example, P⁺-type regions 22-n and 22-(n+1) of SDG region 14 are used as source and drain regions of P channel MOSFET Q2n. Metal wiring layer 23A such as an aluminum layer of low resistance for signal input is formed on part of resistive regions 43 and 44 through insulation layer 10. Contact holes 45 and 46 are formed in insulation layer 10. The widths of contact holes 45 and 46 are set sufficiently smaller than the respective distance between any adjacent two of gate wiring layers 15-1 to 15-n and between any adjacent two of gate wiring layers 20-1 to 20-n. Resistive layers (polysilicon layer) 43 and 44 are connected substantially at their end portions to metal wiring layer 23A through contact holes 45 and 46 formed in insulation layer 10. Metal wiring layer such as an aluminum layer of low resistance 23B for source electrodes is formed on source regions 16-1, 16-3, ..., and 16-n layer 10. Metal wiring layer 23B is grounded. Contact holes 9-1, 9-3, ..., and 9-n are formed in those portions of insulation layer 10 which lie on source regions 16-1, 16-3, ..., and 16-n. Source regions 16-1, 16-3, ..., and 16-n are connected to metal wiring layer 23B through contact holes 9-1, 9-3, ..., and 9-n. Metal wiring layer 23C of low resistance such as an aluminum layer serving as drain electrodes of MOSFETs Q11 to Q1n and Q21 to Q2n is formed on drain regions 16-2, 16-4, ..., and 16-(n+1) and 22-2, 22-4, ..., and 22-(n+1) of N and P channel MOSFETs Q11 to Q1n and Q21 to Q2n through insulation layer 10. Metal wiring layer 23C is connected to output terminal 42. Contact holes 9-2, 9-4, ..., and 9-(n+1) and 8-2, 8-4, ..., and 8-(n+1) are formed in those portions of insulation layer 10 which lie on drain regions 16-2, 16-4, ..., and 16-(n+1) and 22-2, 22-4, ..., and 22-(n+1). Drain regions 16-2, 16-4, ..., and 16-(n+1) and 22-2, 22-4, ..., and 22-(n+1) are connected to metal wiring layer 23C through contact holes 9-2, 9-4, ..., and 9-(n+1) and 8-2, 8-4, ..., 8-(n+1). Metal wiring layer 23D of low resistance such as an aluminum layer serving as source electrodes is formed on source regions 22-1, 22-3, ..., and 22-n of P channel MOSFETs Q21 to Q2n through insulation layer 10. Metal wiring layer 23D is connected to power source Vcc. Contact holes 8-1, 8-3, ..., and 8-n are formed in those portions of insulation layer 10 which lie on source regions 22-1, 22-3, ..., and 22-n. Source regions 22-1, 22-3, ..., and 22-n are connected to metal wiring layer 23D through contact holes 8-1, 8-3, ..., and 8-n.

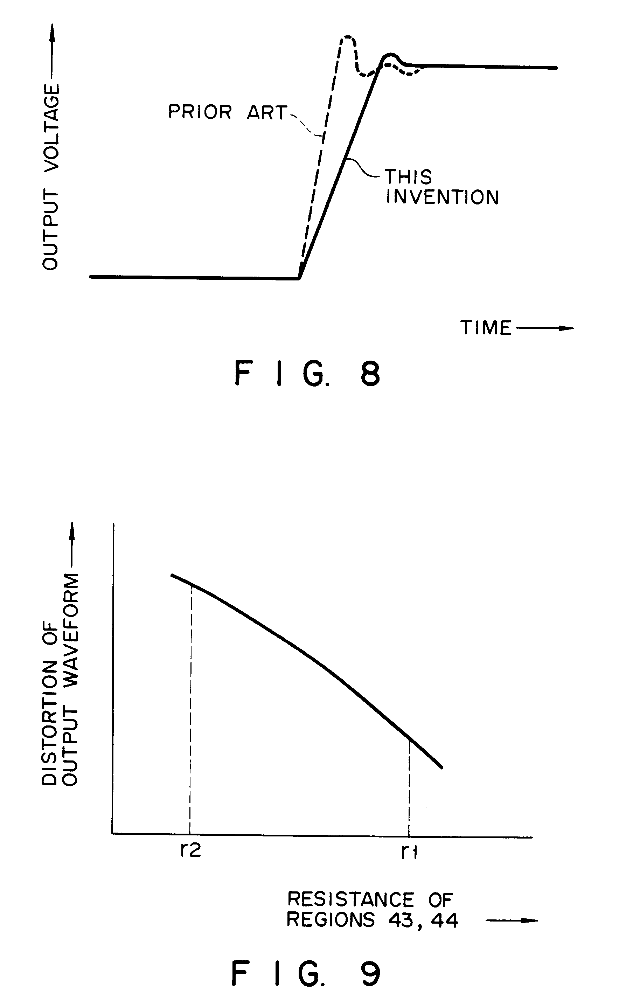

With the construction as described above, when an input signal as indicated by a solid line shown in Fig. 7 is supplied to input terminal 40 (metal wiring layer 23A), the input signal is transmitted from the contact portions (contact holes 45 and 46) to gate wiring layers 15-1, 20-1 and then towards gate wiring layers 15-n, 20-n with delay times which gradually increase with increase in the distance from the contact portions to the gate wiring layers. The time delay of the input signal is caused by the resistance component determined according to the length of the wiring layer which is formed of one of polysilicon layers 43 and 44 of relatively high resistance serving as the signal transmission path and a parasitic gate capacitor associated with each MOSFET. In the case where the input signal is transmitted with different delay times to the gates of MOSFETs Q11 to Q1n and Q21 to Q2n as described above, the MOSFETs are sequentially operated in a sequence from the MOSFETs having gate wiring layers 15-1 and 20-1 which are located near the contact portions (contact holes 45 and 46) to the MOSFETs having gate wiring layers 15-n and 20-n which are located at the farthest position from the contact portion. For example, when an input signal supplied to input terminal 40 changes from "H" level to "L" level as indicated by the solid line in Fig. 7, an output signal of first CMOS inverter 41-1 is first set to "H" level. Then, after the delay time determined by resistors R11 and R21 and the gate capacitances of MOSFETs Q12 and Q22, an output signal of second CMOS inverter 41-2 is set to "H" level. Next, after the delay time determined by resistors R11, R12, R21 and R22 and the gate capacitances of MOSFETs Q13 and Q23, an output signal of third CMOS inverter 41-3 is set to "H" level. In the same manner as described above, output signals of fourth to n-th CMOS inverters are sequentially set to "H" level.

Thus, the waveform of an output signal of the output buffer shown in Figs. 5 and 6 will take the form as shown by the solid line in Fig. 8. The variation slope of the output voltage is gentle in comparison with the prior art waveform indicated by broken lines in Fig. 8. This reduces the distortion such as overshoot and undershoot of the output voltage. In this case, since difference between delay times of the input signal supplied to the gates of the MOSFETs depends on the resistance of resistive regions 43 and 44, the distortion of the output voltage will depend on the resistance of the resistive regions. The dependency of the distortion on the resistance is shown in Fig. 9. In Fig. 9, resistance r1 corresponds to the pattern layout of this invention shown in Fig. 6 and resistance r2 corresponds to the pattern layout shown in Fig. 1. As is clearly seen from Fig. 9, the distortion of the output voltage decreases as the resistance increases.

With this construction as described above, the distortion of the output waveform can be reduced by properly designing the contact areas between comb-like polysilicon layers 18 and 19 and metal wiring layer 23A for signal input.

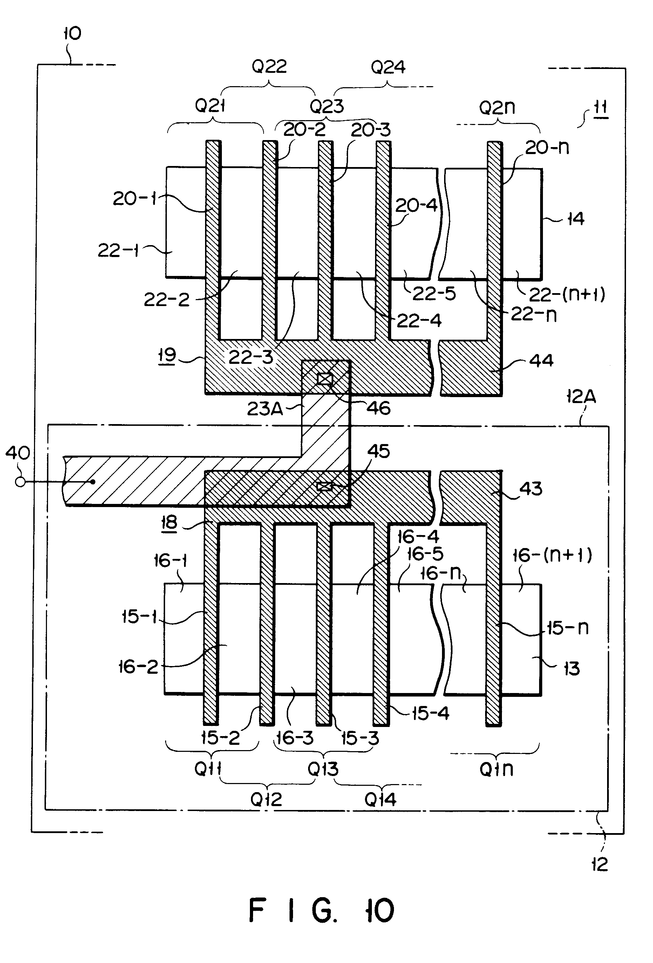

Fig. 10 shows the pattern layout of an output buffer according to another embodiment of this invention. In Fig. 10, portions corresponding to those in Fig. 6 are denoted by the same reference numerals and the detail explanation thereof is omitted. In the pattern layout of Fig. 10, metal wiring layers 23B, 23C and 23D for forming source and drain regions in Fig. 6 are omitted for brevity of the explanation and drawing. The pattern of Fig. 10 differs from that of Fig. 6 in the positions where contact holes 45 and 46 are formed. That is, in the pattern of Fig. 6, contact holes 45 and 46 are formed in end portions of polysilicon layers 43 and 44 or in positions nearest to gate electrodes 15-1 and 20-1. However, in the pattern of Fig. 10, the contact holes are formed in positions nearest to gate electrodes 15-3 and 20-3 and polysilicon layers 43 and 44 are connected to metal wiring layer 23A via contact holes 45 and 46. With this pattern layout, it is equivalent to the case where an input signal is supplied to the connection nodes between resistors R12 and R13 and resistors R22 and R23 in the circuit of Fig. 5. In this case, third CMOS inverter 41-3 in the circuit of Fig. 5 is first operated in response to an input signal and then second and fourth CMOS inverters 41-2 and 41-4 are operated at the same time. Further, first and fifth CMOS inverters 41-1 and 41-5 are operated at the same time. After this, sixth to n-th CMOS inverters 41-6 to 41-n are sequentially operated. Thus, two CMOS inverters may be operated at the same time, causing the output waveform to contain distortion slightly larger than that in the case of the pattern layout of Fig. 6. However, the distortion of the output waveform can be greatly reduced in comparison with that in the pattern layout shown in Fig. 1, thus making it unnecessary to use externally connected parts such as planar diodes 37 and 38 and inductor 39 for ultraspeed switching operation.

The positions of contact holes 45 and 46 are not limited to those shown in Fig. 10 and the same effect can be attained even if they are moved to a certain amount in a lateral direction.

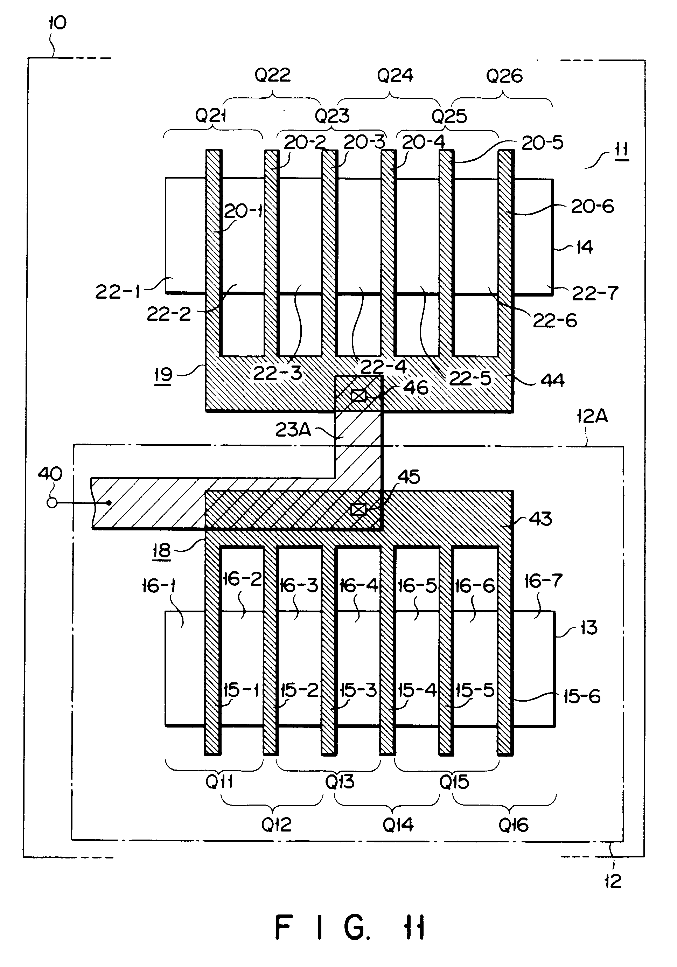

Fig. 11 shows the pattern layout of an output buffer according to another embodiment of this invention. In Fig. 11, portions corresponding to those in Figs. 6 and 10 are denoted by the same reference numerals and the detail explanation thereof is omitted. The pattern of Fig. 11 differs from those of Figs. 6 and 10 in the positions where contact holes 45 and 46 are formed. That is, in the pattern of Fig. 11, contact holes 45 and 46 are formed on resistive regions 43 and 44 in positions corresponding to the central portions of gate electrodes 15-1 to 15-6 and 20-1 to 20-6. With this pattern layout, third and fourth CMOS inverters 41-3 and 41-4 are first operated in response to an input signal and then second and fifth CMOS inverters 41-2 and 41-5 are operated at the same time. Further, first and sixth CMOS inverters 41-1 and 41-6 are operated at the same time. Thus, two CMOS inverters may be sequentially operated at the same time. In this case, substantially the same effect as that in the former embodiments can be attained.

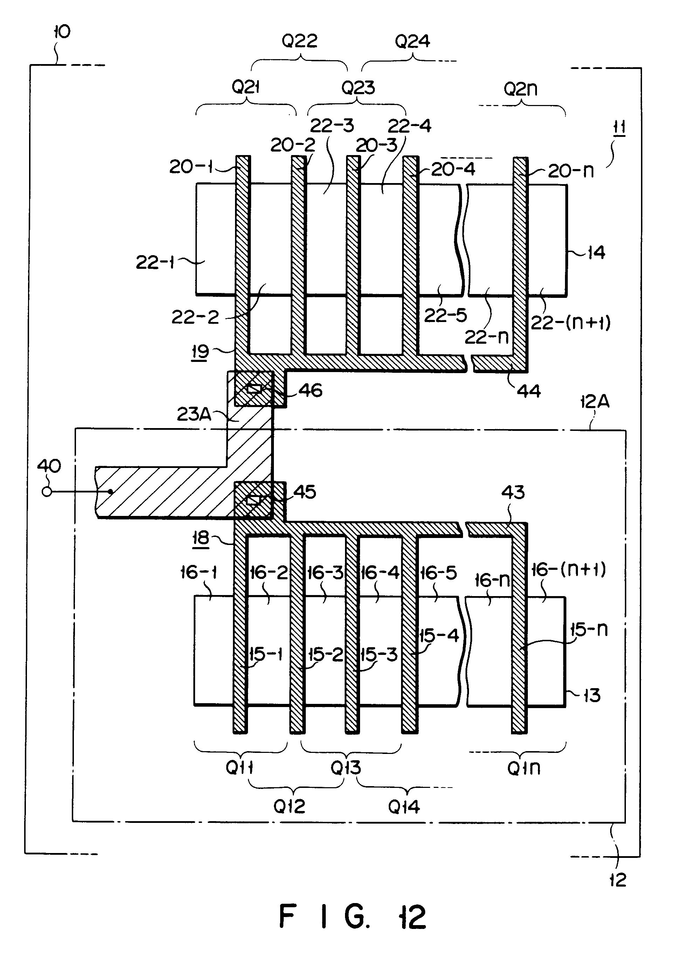

Fig. 12 shows the pattern layout of an output buffer according to still another embodiment of this invention. In Fig. 12, portions corresponding to those in Fig. 6 are denoted by the same reference numerals and the detail explanation thereof is omitted. In the pattern of Fig. 12, the pattern of the polysilicon layers used as resistive layers 43 and 44 in Fig. 6 are formed narrower. The resistance of polysilicon layers 43 and 45 can be increased by narrowing the width of polysilicon layers 43 and 44, thus increasing the resistances of resistors R11 to R1(n+1) and R21 to R2(n-1) in the Fig. 5 circuit. With this pattern layout, the delay times by which the sequential operations of the first to n-th CMOS inverters are delayed are set longer in comparison with those in the pattern layout of Fig. 6. Therefore, variation in the waveform becomes gentler than that in the pattern layout of Fig. 5. Thus, the delay times of the CMOS inverter can be freely controlled by variously setting the widths of polysilicon layers 43 and 44. Further, the same effect as that obtained in Fig. 12 can be attained by setting the concentration of impurity doped into resistive layers (polysilicon layers) 43 and 44 in Figs. 6, 10 and 11 lower than that in gate wiring layers 15-1 to 15-n and 20-1 to 20-n.

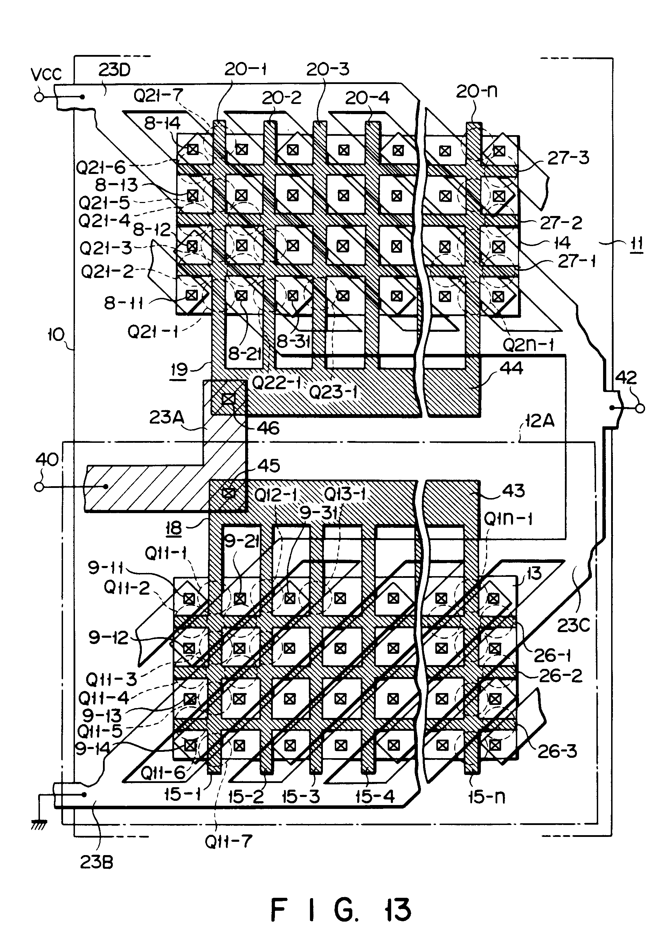

Fig. 13 shows the pattern layout of an output buffer according to another embodiment of this invention which is attained by applying this invention to the pattern layout of Fig. 2. In Fig. 13, portions corresponding to those in Fig. 2 are denoted by the same reference numerals and the detail explanation thereof is omitted. The pattern of Fig. 13 differs from those of Fig. 2 in the size and positions of contact holes 45 and 46. That is, in the pattern layout contact holes 45 and 46 are formed at the end portions of resistive regions 43 and 44 and metal wiring layer 23A is connected to resistive regions 43 and 44 via contact holes 45 and 46. The widths of contact holes 45 and 46 are made smaller than the interval between any adjacent two of gate wiring layers 15-1 to 15-n, and between any adjacent two of gate wiring layers 20-1 to 20-n.

With this pattern layout, MOSFETs Q11-1 and Q21-1 which are located nearest to contact holes 45 and 46 are first operated. That is, the MOSFETs are sequentially operated in the order from MOSFETs Q11-1, Q21-1 to Q1n-1, Q2n-1 and from MOSFETs Q11-1, Q21-1 to Q11-7, Q21-7. Thus, in the same manner as in the former embodiments, variation of the output waveform can be made gentle, preventing generation of overshoot and undershoot of the output waveform without externally connecting a distortion reducing circuit.

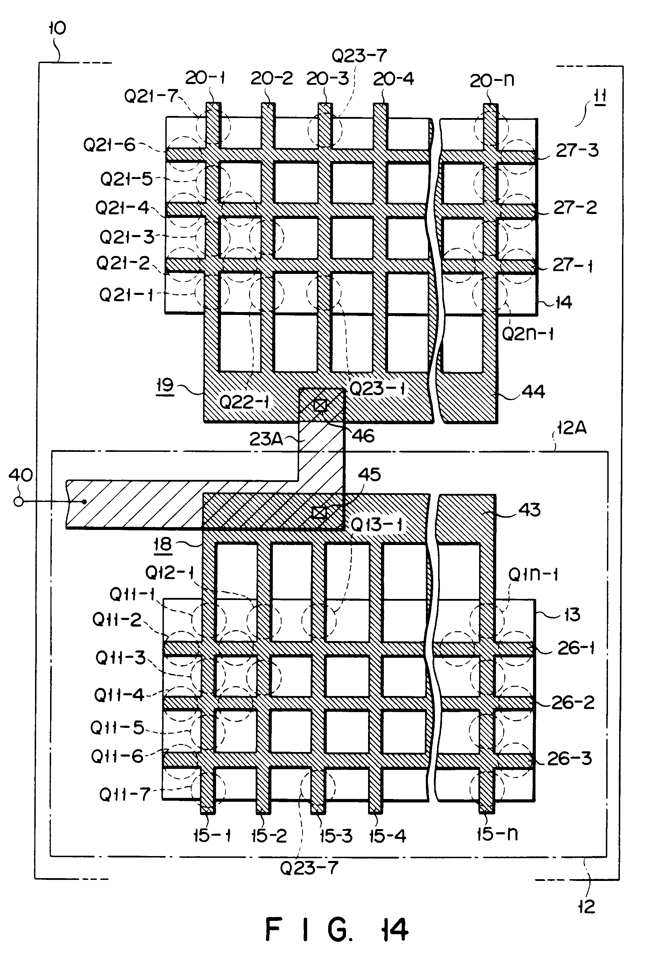

Fig. 14 shows the pattern layout of an output buffer according to another embodiment of this invention. In Fig. 14, portions corresponding to those in Fig. 13 are denoted by the same reference numerals and the detail explanation thereof is omitted. In the pattern layout of Fig. 14, metal wiring layers 23B, 23C and 23D for forming source and drain regions in Fig. 13 are omitted for brevity of the explanation and drawing. The pattern of Fig. 14 differs from that of Fig. 13 in the positions where contact holes 45 and 46 are formed. That is, in the pattern of Fig. 13, contact holes 45 and 46 are formed in end portions of resistive regions (polysilicon layers) 43 and 44 or in positions nearest to gate electrodes 15-1 and 20-1. However, in the pattern of Fig. 14, the contact holes are formed in positions nearest to gate electrodes 15-3 and 20-3. With this pattern layout, MOSFETs Q13-1 and Q23-1 nearest to contact holes 45 and 46 are first operated in response to an input signal and then MOSFETs are sequentially operated in a direction from MOSFETs Q13-1, Q23-1 towards MOSFETs Q11-1, Q21-1 and Q1n-1, Q2n-1, and in a direction from MOSFETs Q13-1, Q23-1 towards Q13-7, Q23-7. Thus, the number of MOSFETs (CMOS inverters) which are operated at the same time increases, causing the output waveform to contain distortion slightly larger than that in the case of the pattern layout of Fig. 13. However, the distortion of the output waveform can be greatly reduced in comparison with that in the pattern layout shown in Fig. 2, thus making it unnecessary to use an externally connected distortion reducing circuit.

The positions of the contact holes are not limited to those shown in Fig. 14 and the same effect can be attained even if they are moved to a certain amount.

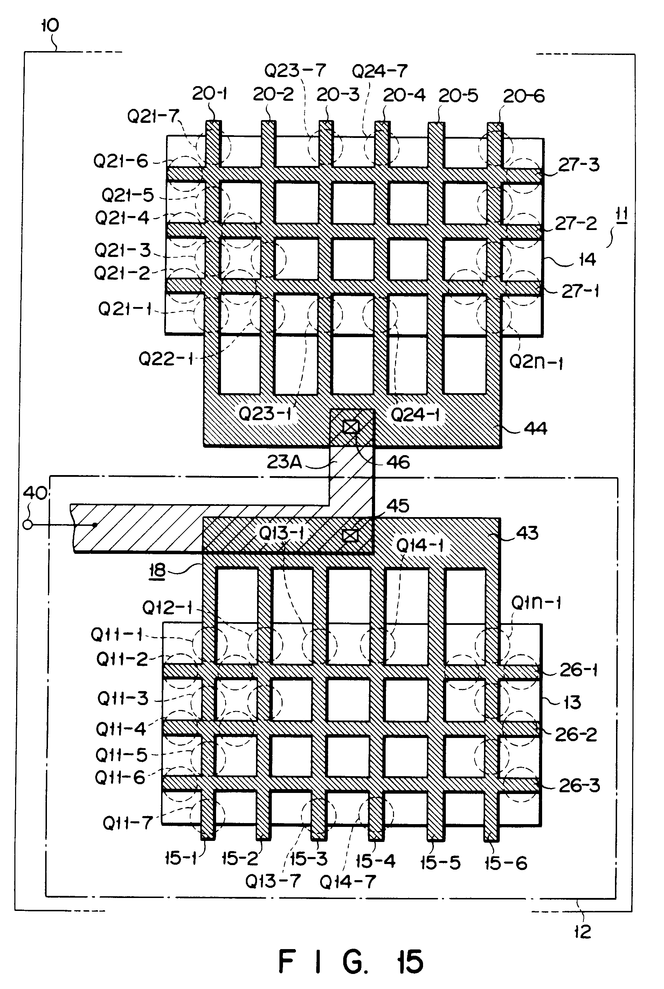

Fig. 15 shows the pattern layout of an output buffer according to another embodiment of this invention. In Fig. 15, portions corresponding to those in Figs. 13 and 14 are denoted by the same reference numerals and the detail explanation thereof is omitted. The pattern of Fig. 15 differs from those of Figs. 13 and 14 in the positions of contact holes 45 and 46. That is, the contact holes are formed on central portions of resistive regions 43 and 44. With this pattern layout, MOSFETs Q13-1, Q14-1, Q23-1 and Q24-1 are first operated at the same time in response to an input signal. Then, the MOSFETs are sequentially operated in directions from MOSFETs Q13-1, Q23-1 towards MOSFETs Q11-1, Q21-1 and from MOSFETs Q14-1, Q24-1 towards MOSFETs Q1n-1, Q2n-1 and in directions from MOSFETs Q13-1, Q14-1, Q23-1 and Q24-1 towards MOSFETs Q13-7, Q14-7, Q23-7 and Q24-7. Thus, the number of MOSFETs which are operated at the same time becomes larger in comparison with the case in the pattern layout of Fig. 13. However, the number of MOSFETs operated at the same time is relatively smaller than the total number of the MOSFETs used, and therefore the same effect as that in the former embodiments can be attained.

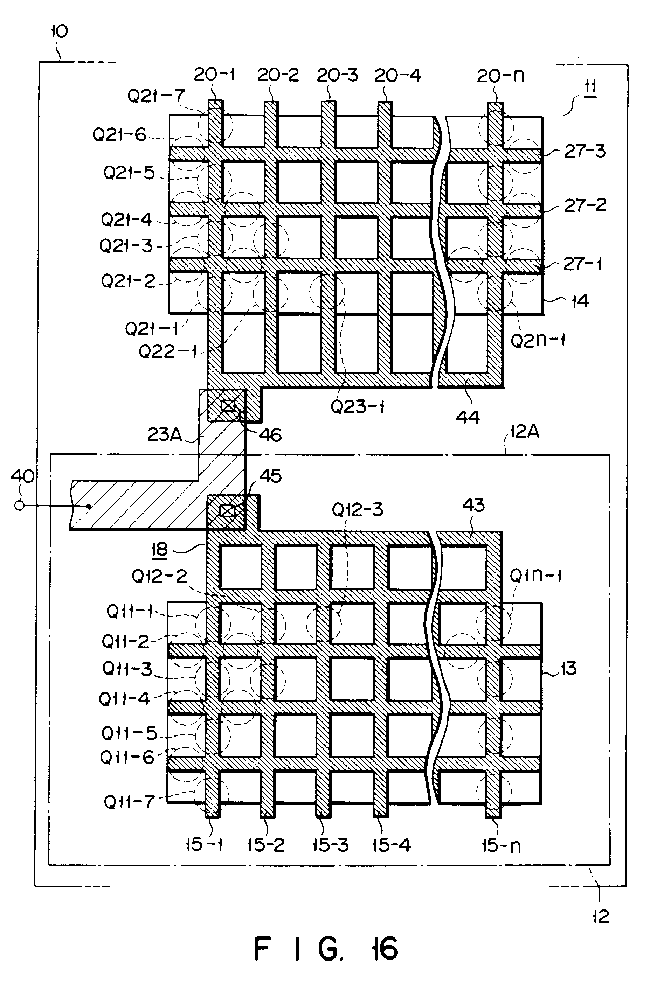

Fig. 16 shows the pattern layout of an output buffer according to still another embodiment of this invention. In Fig. 16, portions corresponding to those in Fig. 13 are denoted by the same reference numerals and the detail explanation thereof is omitted. The pattern of Fig. 16 is obtained by narrowing the width of resistive layers (polysilicon layers) 43 and 44 in the pattern of Fig. 13. The resistance of polysilicon layers 43 and 45 can be increased by narrowing the width of polysilicon layers 43 and 44, thus increasing the resistances of resistors connected to the gate of each MOSFET. With this pattern layout, the delay times by which the sequential operations of the MOSFETs are delayed are set longer in comparison with those in the pattern layout of Fig. 13. Therefore, variation in the waveform becomes gentler than that of the pattern layout in Fig. 13. Thus, the delay times of the MOSFETs can be freely controlled by variously setting the widths of the polysilicon layers. Further, the same effect as that obtained in Fig. 16 can be attained by setting the concentration of impurity doped into resistive layers (polysilicon layers) 43 and 44 in Figs. 13 to 15 lower than that in gate wiring layers 15-1 to 15-n, 20-1 to 20-n, 26-1 to 26-3 and 27-1 to 27-3.

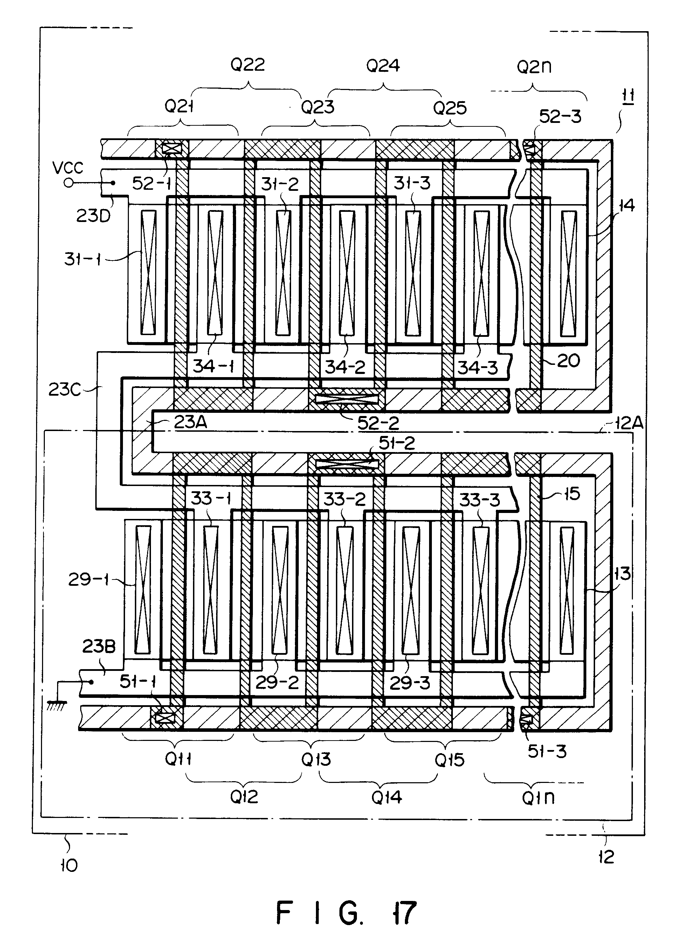

Fig. 17 shows the pattern layout of an output buffer according to still another embodiment of this invention which is attained by applying this invention to the pattern layout of Fig. 3. In the pattern layout of Fig. 17, gate electrodes for forming MOSFETs Q11 to Q1n which are connected in parallel are formed of one polysilicon layer 15 bent in the form of rectangular waveform, and gate electrodes for forming MOSFETs Q21 to Q2n are formed of one polysilicon layer 20 bent in the form of a rectangular waveform in the same manner as in the pattern layout of Fig. 3. Metal wiring layers 23A of low resistance for signal input are formed on the bent portions of polysilicon layers 15 and 20 serving as gate electrodes through insulation layer 10. Contact holes 51-1 to 51-3 and 52-1 to 52-3 are formed in insulation layer 10 in positions under the bent portions of gate electrodes 15 and 20. Gate electrodes 15 and 20 are connected to metal wiring layer 23A via contact holes 51-1 to 51-3 and 52-1 to 52-3 at both ends of gate wiring layers 15 and 20 and at part of the bent portions. Metal wiring layer 23B for the source region is connected to each of the source regions of SDG region 13 via contact holes 29-1, 29-2, 29-3, ... formed in insulation layer 10. Metal wiring layer 23D for the source electrode is connected to each of the source regions of SDG region 14 via contact holes 31-1, 31-2, 31-3, ... formed in insulation layer 10. Metal wiring layer 23C for the drain electrode is connected to each of the drain regions of SDG regions 13 and 14 via contact holes 33-1, 33-2, 33-3, ... and 34-1, 34-2, 34-3, ... formed in insulation layer 10. With this pattern layout, MOSFETs Q11 to Q1n and Q21 to Q2n are formed to have the source and drain regions lying on both sides of respective straight portions of gate wiring layers 15 and 20 which are formed to vertically extend and arranged at a regular interval. The MOSFETs are sequentially operated in the order from the MOSFETs nearest to the contact portions (contact holes 51-1 to 51-3 and 52-1 to 52-3) towards the MOSFETs farthest from the contact portions. Thus, all the MOSFETs are not operated at the same time. Therefore, as in the former embodiments, the distortion of the output waveform can be reduced without externally connecting a distortion reducing circuit even if the mutual conductance of the MOSFET is increased.

In the embodiment of Fig. 17, three contact portions are formed between metal wiring layer 23A and each of gate wiring layers 15 and 20. However, one or two contact portions may be sufficient, and more than three contact portions may be provided if the number n of the MOSFETs is extremely larger than the number of the contact portions.

In the embodiments described above, the output buffer of CMOS structure is used. However, in this invention, it is possible to constitute the output buffer of one channel MOS structure by using only P or N channel MOSFETs.

## Claims

1. An output buffer of a MOS semiconductor integrated circuit for amplifying an input signal from a preceding stage and outputting the amplified signal, comprising a semiconductor substrate (11; 12); a device region (13; 14) which is formed in the surface area of said semiconductor substrate (11; 12) and in which are formed sources, drains, and gates of a plurality of MOSFETs (Q11 to Q1n; Q21 to Q2n) connected in parallel to the output terminal (23C) of said buffer; gate wiring layers (15-1 to 15-n, 20-1 to 20-n) arranged in parallel and spaced by a predetermined distance on said device region (13; 14), to serve as gate electrodes of said MOSFETs (Q11 to Q1n; Q21 to Q2n); and a common resistive region (43; 44) formed of the same material as said gate wiring layers (15-1 to 15-n; 20-1 to 20-n) and connected to one end of each of said gate wiring layers (15-1 to 15-n; 20-1 to 20-n) to form a gate wiring structure in the form of a comb-like pattern or a lattice pattern, an insulation layer (10) formed on said device region (13; 14), said gate wiring layers (15-1 to 15-n; 20-1 to 20-n), and said resistive region (43; 44); a single contact hole (45; 46) which is formed in said insulation layer (10) at a position above part of said resistive region (43; 44); and a metal wiring layer (23A) connected to a signal input terminal, formed on said insulation layer (10) and connected to the resistive region (43; 44) via said contact hole (45; 46); characterized in that the width of said contact hole (45; 46) is less than the distance between any adjacent two of said gate wiring layers (15-1 to 15-n; 20-1 to 20-n), so that the sum of the effective resistances of the gate wiring layer of a given MOSFET (15-1 to 15-n; 20-1 to 20-n) and said resistive region (43; 44) lying between the gate electrode of said MOSFET and said contact hole (45; 46) increases with the distance of said MOSFET from said contact hole, and that said MOSFETs are operated sequentially by an input signal.

2. An output buffer of a MOS semiconductor integrated circuit according to claim 1, characterized in that said gate wiring layers (15-1 to 15-n; 20-1 to 20-n) and said resistive region (43; 44) are formed of a polysilicon layer (18; 19) in the form of a comb-like pattern.

3. An output buffer of a MOS semiconductor integrated circuit according to claim 1, which further comprises a plurality of additional gate wiring layers (26-1 to 26-3; 27-1 to 27-3) arranged at a predetermined distance, to intersect with said former gate wiring layers (15-1 to 15-n, 20-1 to 20-n) and in which said former and additional gate wiring layers (15-1 to 15-n and 26-1 to 26-3; 20-1 to 20-n and 27-1 to 27-3) are formed of a polysilicon layer (18; 19) in the form of a lattice pattern which are used as gate electrodes of said MOSFETs (Q11-1, Q11-2, ..., ; Q21-1, Q21-2, ...).

4. An output buffer of a MOS semiconductor integrated circuit according to claim 1, characterized in that said semiconductor substrate (11; 12) comprises a first substrate region (11) of a first conductivity type and a well region (12) of a second conductivity type formed in said first substrate region (11); said device region (1,14) comprises a first device region unit (13) which is formed in the surface area of said well region (12) and in which are formed sources, drains, and gates of a first plurality of said plurality of MOSFETs (Q11 to Q1n) and a second device region unit (14) which is formed in the surface area of said first substrate region (11), and in which are formed sources, drains, and gates of a second plurality of said plurality of MOSFETs (Q21 to Q2n) and; said gate wiring layers comprise first gate wiring layer units which are formed to extend on said first device region unit (13) and serve as gate electrodes of said first plurality of MOSFETs (Q11 to Q1n) of a first channel type on said first device region unit (13), and second gate wiring layer units (20-1 to 20-n) which are formed to extend on said second device region unit (14) and serve as gate electrodes of said second plurality of MOSFETS (Q21 to Q2n) of a second channel type on said second device region unit (13); said resistive region (43; 44) comprises a first resistive region unit (43) formed of the same layer as that of said first gate electrode units (15-1 to 15-n) and connected to one end of each of said first gate electrode units (15-1 to 15-n) and a second resistive region (44) formed on the same layer as that of said second gate electrode units (20-1 to 20-n) and connected to one end of each of said second gate electrode units (20-1 to 20-n).

5. An output buffer of a MOS semiconductor integrated circuit according to claim 4, characterized in that said first gate wiring layer units (15-1 to 15-n) and said first resistive region unit (43) are formed of a first polysilicon layer (18) in the form of a comb pattern, and said second gate wiring layer units (20-1 to 20-n) and said second resistive regions (44) are formed of a second polysilicon layer (19) in the form of a comb pattern which is arranged symmetrically with said first polysilicon layer (18) about the junction boundary (12A) between said first region of said semiconductor substrate (11) and said well region (12).

6. An output buffer of a MOS semiconductor integrated circuit according to claim 4, characterized by further comprising a plurality of additional gate wiring layers (26-1 to 26-3 and 27-1 to 27-3) composed of polysilicon layers arranged at a regular interval to intersect with said first and second gate wiring layer units (15-1 to 15-n and 20-1 to 20-n), to form first and second lattice patterns together with said first and second gate electrode units (15-1 to 15-n and 20-1 to 20-n), said polysilicon layers of first and second lattice patterns being arranged symmetrically with each other about the junction boundary line (12A) between said first region of said semiconductor substrate (11) and said well region (12), and serving as gate wiring layers of said MOSFETs (Q11-1, Q12, ..., and Q21, Q22, ...).

7. An output buffer of a MOS semiconductor integrated circuit for amplifying an input signal from a preceding stage and outputting the amplified signal, comprising a semiconductor substrate (11; 12); a device region (13; 14) which is formed in the surface area of said semiconductor substrate (11; 12) and in which are formed sources, drains, and gates of a plurality of MOSFETs (Q11 to Q1n; Q21 to Q2n) connected in parallel to the output terminal (23C) of said buffer; gate wiring layers arranged in parallel and spaced by a predetermined distance on said device region (13; 14), to serve as gate electrodes of said MOSFETs (Q11 to Q1n; Q21 to Q2n); and cross-portions farmed of the same material as said gate wiring layers (15-1 to 15-n; 20-1 to 20-n) and connecting the ends of adjacent gate wiring layers to form a gate wiring structure (15, 20) having the shape of a continuous rectangular waveform; an insulation layer (10) formed on said device region (13; 14) and said gate wiring structure (15; 20); contact holes (51-1 to 51-3; to 52-1 to 52-3) formed in said insulation layer (10) at positions above said cross-portions; and a metal wiring layer (23A) connected to a Signal input terminal formed on said insulation layer (10) and connected to said cross-portions via said contact holes (51-1 to 51-3; 52-1 to 52-3); characterized in that contact holes are provided at some of said cross-portions only so that the effective resistance of the gate wiring structure lying between the gate electrode of a given MOSFET and the nearest contact hole (45; 46) increases with the distance of said MOSFET from said contact hole, and that said MOSFETs are operated sequentially by an input signal.

## Patentansprüche

1. Ausgangspuffer einer MOS-integrierten Halbleiterschaltung zur Verstärkung eines Eingangssignals einer vorgeschalteten Stufe und zur Ausgabe des verstärkten Signals, welcher folgendes umfaßt:
ein Halbleitersubstrat (11, 12); eine Gerätezone (13; 14), welche im Oberflächenbereich des Halbleitersubstrats (11; 12) ausgeformt ist und in welcher Sources, Drains und Gates einer Vielzahl von parallel zum Ausgangsanschluß (23C) des Puffers geschalteten MOSFET's (Q11 bis Q1n; Q21 bis Q2n) ausgeformt sind; parallele Gate-Verdrahtungsschichten (15-1 bis 15-n; 20-1 bis 20-n), welche in einem vorgegebenen Abstand auf der Gerätezone (13; 14) angeordnet sind, um als Gate-Elektroden der MOSFET's (Q11 bis Q1n; G21 bis Q2n) zu dienen; und eine gemeinsame Ohmsche bzw. Widerstandszone (43; 44), welche aus dem gleichen Material wie die Gate-Verdrahtungsschichten (15-1 bis 15-n; 20-1 bis 20-n) ausgeformt und mit jeweils einem Ende der Gate-Verdrahtungsschichten (15-1 bis 15-n; 20-1 bis 20-n) gekoppelt sind, um eine Gate-Verdrahtungsstruktur in Form eines kammartigen oder eines Gittermusters zu bilden; eine auf der Gerätezone (13; 14), den Gate-Verdrahtungsschichten (15-1 bis 15-n; und 20-1 bis 20-n) und der Ohmschen Schicht (43; 44) ausgeformte Isolierschicht (10); ein einzelnes Kontaktloch (45; 46), welches in der Isolierschicht (10) an einer Position oberhalb eines Teils der Ohmschen Schicht (43; 44) eingeformt ist; und eine mit einem auf der Isolierschicht (10) ausgeformten und über das Kontaktloch (45; 46) mit der Ohmschen Zone (43; 44) verbundene Metallverdrahtungsschicht (23A);
dadurch gekennzeichnet, daß
die Breite des Kontaktlochs (45; 46) kleiner ist als der Abstand zwischen zwei beliebigen benachbarten Gate-Verdrahtungsschichten (15-1 bis 15-n; und 20-1 bis 20-n), so daß die Summe der effektiven Widerstände der Gate-Verdrahtungsschicht eines gegebenen MOSFET, (15-1 bis 15-n; 20-1 bis 20-n) und der zwischen der Gate-Elektrode dieses MOSFET und dem Kontaktloch (45; 46) liegenden Ohmschen Zone (43; 44) mit dem Abstand des MOSFET von diesem Kontaktloch größer wird und die MOSFET's sequentiell durch ein Eingangssignal angesteuert werden.

2. Ausgangspuffer einer MOS-integrierten Halbleiterschaltung entsprechend Anspruch 1, dadurch gekennzeichnet, daß die Gate-Verdrahtungsschichten (15-1 bis 15-n; 20-1 bis 20-n) und die Ohmsche Schicht (43; 44) in Form einer kammartigen Struktur auf einer Polysiliziumschicht (18; 19) ausgeformt sind.

3. Ausgangspuffer einer MOS-integrierten Halbleiterschaltung entsprechend Anspruch 1, welcher des weiteren eine Vielzahl zusätzlicher Gate-Verdrahtungsschichten (26-1 bis 26-3; 27-1 bis 27-3), die zueinander in einem vorgegebenen Abstand so angeordnet sind, daß sie die zuvor genannten Gate-Verdrahtungsschichten (15-1 bis 15-n; 20-1 bis 20-n) schneiden und in welchem die zuvor genannten und die zusätzlichen Gate-Verdrahtungsschichten (15-1 bis 15-n und 26-1 bis 26-3; 20-1 bis 20-n und 27-1 bis 27-3) aus einer Polysiliziumschicht (18; 19) in Form eines Gittermusters ausgebildet sind und als Gate-Elektroden der MOSFET's (Q11-1, Q11-2, ...,; Q21-1, Q21-2, ...) herangezogen werden.

4. Ausgangspuffer einer MOS-integrierten Halbleiterschaltung entsprechend Anspruch 1, dadurch gekennzeichnet, daß das Halbleitersubstrat (11; 12) eine erste Substratzone (11) eines ersten Leitfähigkeitstyps und eine in der ersten Substratzone (11) ausgeformte Wannenzone (12) eines zweiten Leitfähigkeitstyps umfaßt; wobei die Gerätezone (13; 14) eine erste Gerätezoneneinheit (13), welche in den Oberflächenbereich der Wannenzone (12) eingeformt ist und in welcher Sources, Drains und Gates einer ersten Vielzahl aus der Vielzahl der MOSFET's (Q11 bis Q1n) ausgebildet sind, und eine zweite Gerätezoneneinheit (14), welche in den Oberflächenbereich der ersten Substratzone (11) eingeformt ist und in welcher Sources, Drains und Gates einer zweiten Vielzahl aus der Vielzahl von MOSFET's (Q21 bis Q2n) ausgebildet sind, umfaßt; wobei die Gate-Verdrahtungsschichten erste Gate-Verdrahtungsschichteinheiten, welche so ausgeformt sind, daß sie sich bis auf die erste Gerätezoneneinheit (13) erstrecken und als Gate-Elektroden der ersten Vielzahl von MOSFET's Q11 bis Q1n) eines ersten Kanaltyps auf der ersten Gerätezoneneinheit (13) dienen und zweite Gate-Verdrahtungsschichteinheiten (20-1 bis 20-n), welche so ausgeformt sind, daß sie sich auf die zweite Gerätezoneneinheit (14) erstrecken und als Gate-Elektroden der zweiten Vielzahl von MOSFET's (Q21 bis Q2n) eines zweiten Kanaltyps auf der zweiten Gerätezoneneinheit (14) dienen; wobei die Ohmsche Zone (43; 44) eine erste aus derselben Schicht wie die ersten Gate-Elektrodeneinheiten (15-1 bis 15-n) ausgebildete und mit einem Ende jedes der ersten Gate-Elektrodeneinheiten (15-1 bis 15-n) verbundene Ohmsche Zoneneinheit (43) und eine zweite auf derselben wie die zweiten Gate-Elektrodeneinheiten (20-1 bis 20-n) ausgebildete und mit einem Ende jedes der zweiten Gate-Elektrodeneinheiten (20-1 bis 20-n) verbundene Ohmsche Zoneneinheit (44) umfaßt.

5. Ausgangspuffer einer MOS-integrierten Halbleiterschaltung entsprechend Anspruch 4, dadurch gekennzeichnet, daß die ersten Gate-Verdrahtungsschichteinheiten (15-1 bis 15-n) und die erste Ohmsche Zoneneinheit (43) aus einer ersten Polysiliziumschicht (18) in Form eines Kammusters und die zweiten Gate-Verdrahtungsschichteinheiten (20-1 bis 20-n) und die zweiten Ohmschen Zonen (44) aus einer zweiten Polysiliziumschicht (19) in Form eines Kammusters ausgeformt sind, welches symmetrisch mit der ersten Polysiliziumschicht (18) zu einer Übergangsgrenze (12A) zwischen der ersten Zone das Halbleitersubstrats (11) und der Wannenzone (12) angeordnet ist.

6. Ausgangspuffer einer MOS-integrierten Halbleiterschaltung entsprechend Anspruch 4, dadurch gekennzeichnet, daß er des weiteren eine Vielzahl zusätzlicher Gate-Verdrahtungsschichten (26-1 bis 26-3; 27-1 bis 27-3) umfaßt, welche aus zueinander in einem regelmäßigen Abstand so angeordnet sind, daß sie die die ersten und zweiten Gate-Verdrahtungsschichteinheiten (15-1 bis 15-n und 20-1 bis 20-n) schneiden, um zusammen mit den ersten und zweiten Gate-Elekttrodeneinheiten (15-1 bis 15-n und 20-1 bis 20-n) erste und zweite Gittermuster zu bilden, wobei die Polysiliziumschichten der ersten und zweiten Gittermuster symmetrisch zueinander um die Übergangsgrenzlinie (12A) zwischen der ersten Zone des Halbleitersubstrats (11) und der Wannenzone (12) angeordnet sind und als Gate-Verdrahtungsschichten der MOSFET's (Q11-1, Q12, ..., und Q21, Q22, ...) herangezogen werden.

7. Ausgangspuffer einer MOS-integrierten Halbleiterschaltung zur Verstärkung eines Eingangssignals einer vorgeschalteten Stufe und zur Ausgabe des verstärkten Signals, welcher folgendes umfaßt:
ein Halbleitersubstrat (11, 12); eine Gerätezone (13; 14), welche im Oberflächenbereich des Halbleitersubstrats (11; 12) ausgeformt ist und in welcher Sources, Drains und Gates einer Vielzahl von parallel zum Ausgangsanschluß (23C) des Puffers geschalteten MOSFET's (Q11 bis Q1n; Q21 bis Q2n) ausgeformt sind; parallele Gate-Verdrahtungsschichten (15-1 bis 15-n; 20-1 bis 20-n), welche in einem vorgegebenen Abstand auf der Gerätezone (13; 14) angeordnet sind, um als Gate-Elektroden der MOSFET's (Q11 bis Q1n; G21 bis Q2n) zu dienen; und Querabschnitte, welche aus dem gleichen Material wie die Gate-Verdrahtungsschichten (15-1 bis 15-n; 20-1 bis 20-n) ausgeformt sind und welche die Enden benachbarter Gate-Verdrahtungsschichten zur Bildung einer Gate-Verdrahtungsstruktur (15; 20) in Form einer kontinuierlichen Rechteckwelle koppeln zu bilden; eine auf der Gerätezone (13; 14), der Gate-Verdrahtungsstruktur (15; 20) ausgeformte Isolierschicht (10); Kontaktlöcher (51-1 bis 51-3; 52-1 bis 52-3), welche in der Isolierschicht (10) an Positionen oberhalb der Querabschnitte eingeformt sind; und eine mit einem auf der Isolierschicht (10) ausgeformten und über die Kontaktlöcher (51-1 bis 51-3; 52-1 bis 52-3) mit dem auf der Isolierschicht (10) ausgebildeten Signaleingangsanschluß verbundene Metallverdrahtungsschicht (23A);
dadurch gekennzeichnet, daß die Kontaktlöcher (51-1 bis 51-3; 52-1 bis 52-3) nur an einigen der Querabschnitte vorgesehen sind, so daß der effektive Widerstand der Gate-Verdrahtungsstruktur zwischen der Gate-Elektrode eines gegebenen MOSFET und dem nächstliegenden Kontaktloch (45; 46) mit dem Abstand des MOSFET von diesem Kontaktloch zunimmt und daß die MOSFET's sequentiell durch ein Eingangssignal angesteuert werden.

## Revendications

1. Circuit tampon de sortie d'un circuit intégré à semiconducteur MOS pour amplifier un signal d'entrée issu d'un étage précédent et fournir en sortie le signal amplifié, comprenant un substrat de semiconducteur (11; 12), une région de dispositifs (13; 14) qui est formée dans la zone superficielle dudit substrat de semiconducteur (11; 12) et dans laquelle sont formés les sources, drains et grilles d'une pluralité de transistors à effet de champ MOS (Q11 à Q1n; Q21 à Q2n) connectés en parallèle à la borne de sortie (23C) dudit circuit tampon; des couches de câblage de grilles (15-1 à 15-n, 20-1 à 20-n) disposées en parallèle et espacées d'une distance prédéterminée sur ladite région de dispositifs (13; 14) pour servir d'électrodes de grille desdits transistors à effet de champ MOS (Q11 à Q1n; Q21 à Q2n); et une région résistive commune (43; 44) formée de la même matière que lesdites couches de câblage de grilles (15-1 à 15-n; 20-1 à 20-n) et connectée à une extrémité de chacune desdites couches de câblage de grilles (15-1 à 15-n; 20-1 à 20-n) pour former une structure de câblage de grilles sous la forme d'un motif en forme de peigne ou d'un motif en treillis; une couche d'isolement (10) formée sur ladite région de dispositifs (13; 14), lesdites couches de câblage de grilles (15-1 à 15-n; 20-1 à 20-n) et ladite région résistive (43; 44); un unique trou de contact (45; 46) qui est formé dans ladite couche d'isolement (10) à une position située au-dessus d'une partie de ladite région résistive (43; 44); et une couche métallique de câblage (23A) connectée à une borne d'entrée de signal, formée sur ladite couche d'isolement (10) et connectée à ladite région résistive (43; 44) par l'intermédiaire dudit trou de contact (45; 46), caractérisé en ce que la largeur dudit trou de contact (45; 46) est inférieure à la distance entre deux couches adjacentes quelconques parmi lesdites couches de câblage de grilles (15-1 à 15-n; 20-1 à 20-n), de telle manière que la somme des résistances effectives de la couche de câblage de grille d'un transistor MOS donné (15-1 à 15-n; 20-1 à 20-n) et ladite région résistive (43; 44) située entre l'électrode de grille dudit transistor à effet de champ MOS et ledit trou de contact (45; 46) augmente avec la distance dudit transistor à effet de champ MOS audit trou de contact, et en ce que lesdits transistors à effet de champ MOS sont actionnés séquentiellement par un signal d'entrée.

2. Circuit tampon de sortie d'un circuit intégré à semiconducteur MOS selon la revendication 1, caractérisé en ce que lesdites couches de câblage de grilles (15-1 à 15-n; 20-1 à 20-n) et ladite région résistive (43; 44) sont formées d'une couche de polysilicium (18; 19) réalisée sous la forme d'un motif en forme de peigne.

3. Circuit tampon de sortie d'un circuit intégré à semiconducteur MOS selon la revendication 1, qui comprend en outre une pluralité de couches supplémentaires de câblage de grilles (26-1 à 26-3; 27-1 à 27-3) disposées à une distance prédéterminée pour couper lesdites couches de câblage de grilles antérieures (15-1 à 15-n; 20-1 à 20--n) et dans lesquelles lesdites couches de câblage de grilles antérieures et supplémentaires (15-1 à 15-n et 26-1 à 26-3; 20-1 à 20-n et 27-1 à 27-3) sont formées d'une couche de polysilicium (18; 19) réalisée sous la forme d'un motif en treillis et sont utilisées comme électrodes de grille desdits transistors à effet de champ MOS (Q11-1, Q11-2, ...; Q21-1, Q21-2, ...).

4. Circuit tampon de sortie d'un circuit intégré à semiconducteur MOS selon la revendication 1, caractérisé en ce que ledit substrat de semiconducteur (11; 12) comprend une première région de substrat (11) d'un premier type de conductibilité et une région de caisson (12) d'un deuxième type de conductibilité formée dans ladite première région de substrat (11), ladite région de dispositifs (1, 14) comprend une première unité de région de dispositifs (13) qui est formée dans la zone superficielle de ladite région de caisson (12) et dans laquelle sont formés les sources, drains et grilles d'une première pluralité de ladite pluralité de transistors à effet de champ MOS (Q11 à Q1n), et une deuxième unité de région de dispositifs (14) qui est formée dans la zone superficielle de ladite première région de substrat (11) et dans laquelle sont formés les sources, drains et grilles d'une deuxième pluralité de ladite pluralité de transistors MOS (Q21 à Q2n); et lesdites couches de câblage de grilles comprennent des premières unités de couches de câblage de grilles qui sont formées pour s'étendre sur ladite première unité de région de dispositifs (13) et servent d'électrodes de grille de ladite première pluralité de transistors à effet de champ MOS (Q11 à Q1n) d'un premier type de canal sur ladite première unité de région de dispositifs (13), et des deuxièmes unités de couches de câblage de grilles (20-1 à 20-n) qui sont formées pour s'étendre sur ladite deuxième unité de région de dispositifs (14) et servent d'électrodes de grille de ladite deuxième pluralité de transistors à effet de champ MOS (Q21 à Q2n) d'un deuxième type de canal sur ladite deuxième unité de région de dispositifs (13); ladite région résistive (43; 44) comprend une première unité de région résistive (43) formée de la même couche que celle desdites premières unités d'électrodes de grille (15-1 à 15-n) et connectée à une extrémité de chacune desdites premières unités d'électrodes de grille (15-1 à 15-n), et une deuxième région résistive (44) formée sur la même couche que celle desdites deuxièmes unités d'électrodes de grille (20-1 à 20-n) et connectée à une extrémité de chacune desdites deuxièmes unités d'électrodes de grille (20-1 à 20-n).

5. Circuit tampon de sortie d'un circuit intégré à semiconducteur MOS selon la revendication 4, caractérisé en ce que lesdites premières unités de couches de câblage de grilles (15-1 à 15-n) et ladite première unité de région résistive (43) sont formées d'une première couche de polysilicium (18) réalisée sous la forme d'un motif en forme de peigne, et lesdites deuxièmes unités de couches de câblage de grilles (20-1 à 20-n) et lesdites deuxièmes régions résistives sont formées d'une deuxième couche de polysilicium (19) réalisée sous la forme d'un motif en forme de peigne qui est disposé symétriquement avec ladite première couche de polysilicium (18) par rapport à la frontière de jonction (12A) entre ladite première région dudit premier substrat de semiconducteur (11) et ladite région de caisson (12).

6. Circuit tampon de sortie d'un circuit intégré à semiconducteur MOS selon la revendication 4, caractérisé en ce qu'il comprend en outre une pluralité de couches supplémentaires de câblage de grilles (26-1 à 26-3 et 27-1 à 27-3) composées de couches de polysilicium disposées à intervalles réguliers pour intersecter lesdites première et deuxième unités de couches de câblage de grilles (15-1 à 15-n et 20-1 à 20-n) pour former des premier et deuxième motifs en treillis avec lesdites première et deuxième unités d'électrodes de grille (15-1 à 15-n et 20-1 à 20-n), lesdites couches de polysilicium desdits premier et deuxième motifs en treillis étant disposées symétriquement par rapport à la ligne de frontière de jonction (12A) entre ladite première région dudit substrat de semiconducteur (11) et ladite région de caisson (12), et servant de couches de câblage de grilles des transistors à effet de champ MOS (Q11-1, Q12, ... et Q21, Q22, ...).

7. Circuit tampon de sortie d'un circuit intégré à semiconducteur MOS pour amplifier un signal d'entrée issu d'un étage précédent et fournir en sortie le signal amplifié, comprenant un substrat de semiconducteur (11; 12); une région de dispositifs (13; 14) qui est formée dans la zone superficielle dudit substrat de semiconducteur (11; 12) et dans laquelle sont formés les sources, drains et grilles d'une pluralité de transistors à effet de champ MOS (Q11 à Q1n; Q21 à Q2n) connectés en parallèle à la borne de sortie (23C) dudit circuit tampon; des couches de câblage de grilles disposées en parallèle et espacées d'une distance prédéterminée sur ladite région de dispositifs (13; 14) pour servir d'électrodes de grille desdits transistors à effet de champ MOS (Q11 à Q1n; Q21 à Q2n); et des parties transversales formées sur la même matière que lesdites couches de câblage de grilles (15-1 à 15-n; 20-1 à 20-n) et reliant les extrémités de couches voisines de câblage de grilles pour former une structure de câblage de grilles (15; 20) ayant la forme d'une forme d'onde rectangulaire continue; une couche d'isolement (10) formée sur ladite rédion de dispositifs (13; 14) et ladite structure de câblage de grilles (15; 20); des trous de contact (51-1 à 51-3; 52-1 à 52-3) formés dans ladite couche d'isolement (10) à des positions situées au-dessus desdites parties transversales; et une couche métallique de câblage (23A) connectée à une borne d'entrée de signal formée sur ladite couche d'isolement (10) et connectée auxdites parties transversales par l'intermédiaire desdits trous de contact (51-1 à 51-3 et 52-1 à 52-3), caractérisé en ce que les trous de contact ne sont prévus que pour certaines desdites parties transversales de telle manière que la résistance effective de la structure de câblage de grilles située entre l'électrode de grille d'un transistor à effet de champ MOS donné et le trou de contact (45; 46) le plus proche augmente avec la distance dudit transistor à effet de champ MOS audit trou de contact, et en ce que lesdits transistors à effet de champ MOS sont actionnés séquentiellement par un signal d'entrée.
